Europäisches Patentamt

European Patent Office

Office européen des brevets

(11) Publication number: **0 173 307**
**A2**

(12) **EUROPEAN PATENT APPLICATION**

(21) Application number: **85110811.8**

(22) Date of filing: **28.08.85**

(51) Int. Cl.⁴: **H 03 H 17/06**

(30) Priority: **31.08.84 JP 180535/84**

(43) Date of publication of application: **05.03.86**
**Bulletin 86/10**

(84) Designated Contracting States: **DE FR GB**

(71) Applicant: **HITACHI, LTD., 6, Kanda Surugadai 4-chome Chiyoda-ku, Tokyo 100 (JP)**

(72) Inventor: **Nakamura, Masafumi, Hitachi keimeiryo, 850 Maioka-cho Totsuka-ku, Yokohama-shi Kanagawa-ken (JP)**
Inventor: **Nakai, Nobuo Hitachi Shirakawaryo, 67-5, Michishita Noguchi-cho, Toyokawa-shi Aichi-ken (JP)**
Inventor: **Shibuya, Toshifumi Wakamatsu-so, 62-9, Higashimatano-cho Totsuka-ku, Yokohama-shi Kanagawa-ken (JP)**

(74) Representative: **Altenburg, Udo, Dipl.-Phys. et al, Patent- und Rechtsanwälte Bardehle-Pagenberg-Dost-Altenburg-Frohwitter & Partner Postfach 86 06 20, D-8000 München 86 (DE)**

(54) **Nonrecursive digital filter.**

(57) In a nonrecursive digital filter, there are provided first and second memories (1, 2) for storing input signals, and a control circuit (3) for controlling the first and second memories to store input signals as two memory channels or as one memory channel.

The sampling frequency of the input signals is converted to higher or lower one in the nonrecursive digital filter.

Hitachi, Ltd.
6, Kanda Surugadai 4-chome
Chiyoda-ku, Tokyo, Japan

- 1 -

Description

TITLE OF THE INVENTION

NONRECURSIVE DIGITAL FILTER

BACKGROUND OF THE INVENTION

The present invention relates to a digital filter, especially to a nonrecursive digital filter appropriate to convert the sampling frequency of the input data.

For the method of constructing a nonrecursive digital filter, as is shown in the official gazette of Japanese Patent Application Laid-Open No.92146/1976, the way is known that the convolution between the data stored in the memory and the filter coefficients are carried out by providing one memory system for storing the input signals, multiplicative means for multiplying constant coefficients which determine the characteristics of the filter, and an adder for adding the results of the multiplier.

This is the method of constructing a nonrecursive digital filter without converting the sampling frequency of the input signals. However, it has not been considered to use a nonrecursive digital filter as the converter of the sampling frequency and to take the outputs converting the sampling frequency of the input signals.

Especially, in a digital audio system, the nonrecursive digital filter enabling the conversion of the sampling frequency is desired in order to convert digital signals to analog signals after setting to higher sampling frequency of the signals prior to the digital to analog converter or to process the signals after setting to higher sampling frequency of an analog to digital converter, and then lower the sampling frequency.

SUMMARY OF THE INVENTION

An object of the present invention is to provide the nonrecursive digital filter which enables to convert the sampling frequency of the input signals to m times or 1/n (m=2,3,4,..., n=2,3,4,...), and to produce the output with a converted sampling frequency.

The above object is accomplished by the present invention which provide a nonrecursive digital filter comprising: a first memory for storing input signals, a second memory for storing input signals, a coefficient memory for storing constant coefficients, a multiplier for multiplying the signal stored in the first and second memories by the constant coefficients stored in the coefficient memory, an adder for adding the output of the multiplier to the output thereof, and a control circuit for controlling whether to use the first and the second memories storing input signals as two independent memory channels or as one memory channel.

BRIEF DESCRIPTION OF THE DRAWINGS

Fig. 1 is a block diagram showing an embodiment of the present invention;

Fig. 2 is a diagram showing a transfer function of a filter;

Fig. 3 is a diagram showing the impulse response of the filter whose transfer function is shown in Fig. 2;

Fig. 4 is a diagram showing time series of input signals;

Fig. 5A is a diagram illustrating a spectrum of the input signal;

Figs. 5B to 5D are diagrams illustrating spectra of time series signals obtained as results of multiplicative operations;

Figs. 6A and 6B are timing charts showing operations of the embodiment shown in Fig. 1;

Fig. 7 is a block diagram showing another embodiment of the present invention;

Fig. 8 is a block diagram showing a digital audio system; and

Fig. 9 is a block diagram illustrating third embodiment of the present invention;

DETAILED DESCRIPTION OF PREFERRED EMBODIMENT

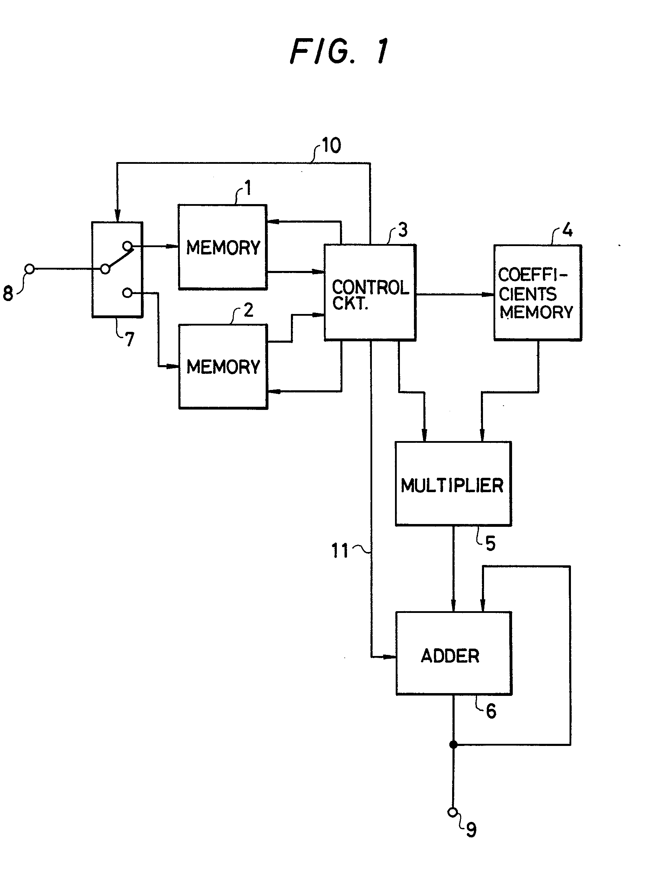

In the following, an embodiment of the present invention will be explained referring to Fig. 1. In Fig. 1, reference numerals 1 and 2 denote memories which respectively store the input signal, 3 denotes a control circuit for the memories 1 and 2, 4 a memory which stores constant coefficients determining the characteristics of the filter, 5 a multiplier which multiply constant coefficients by the input signals stored in the memories 1 and 2, 6 an adder which accumulates the results of the multiplications, and 7 a switch for exchanging the input signals. Reference numeral 8 designates input signals, 9 output signals, 10 the signal for exchanging switch 7, and 11 the clear signal applied to the adder.

In this embodiment, for simplicity, only the case of converting the sampling frequency to 2 times and to 1/2 are explained.

In the following, the performances of converting the sampling frequency of the input signals to 2 times and 1/2 are explainred referring to Fig. 1 through Fig. 6. In the first, when the sampling frequency of the input signals is fs, the principle of converting it to 2 times (2fs) is explained.

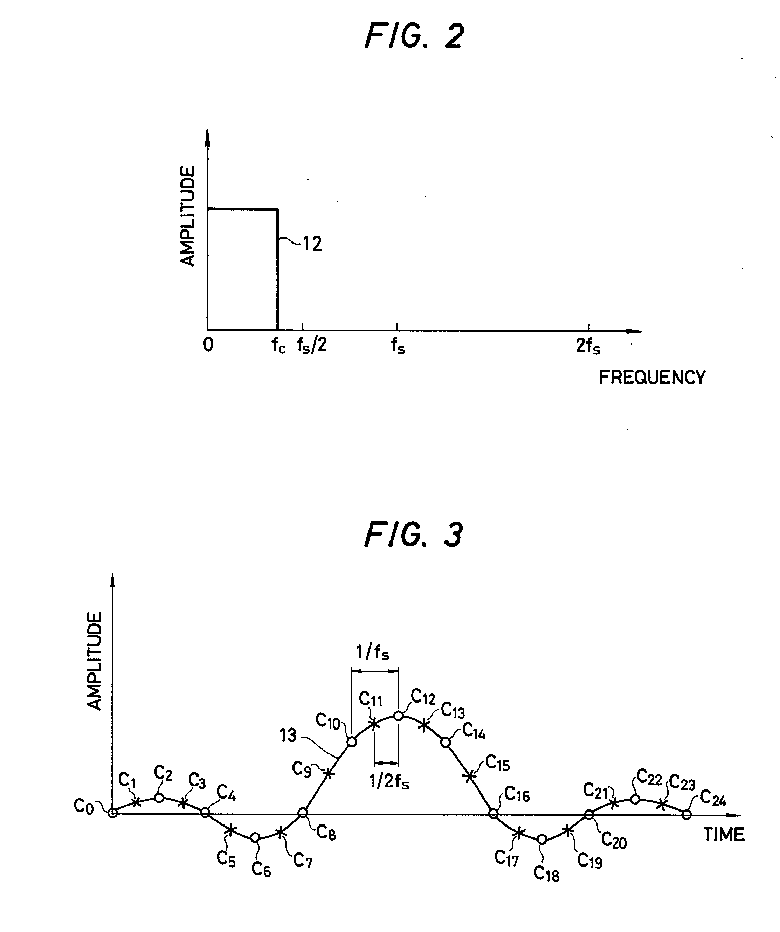

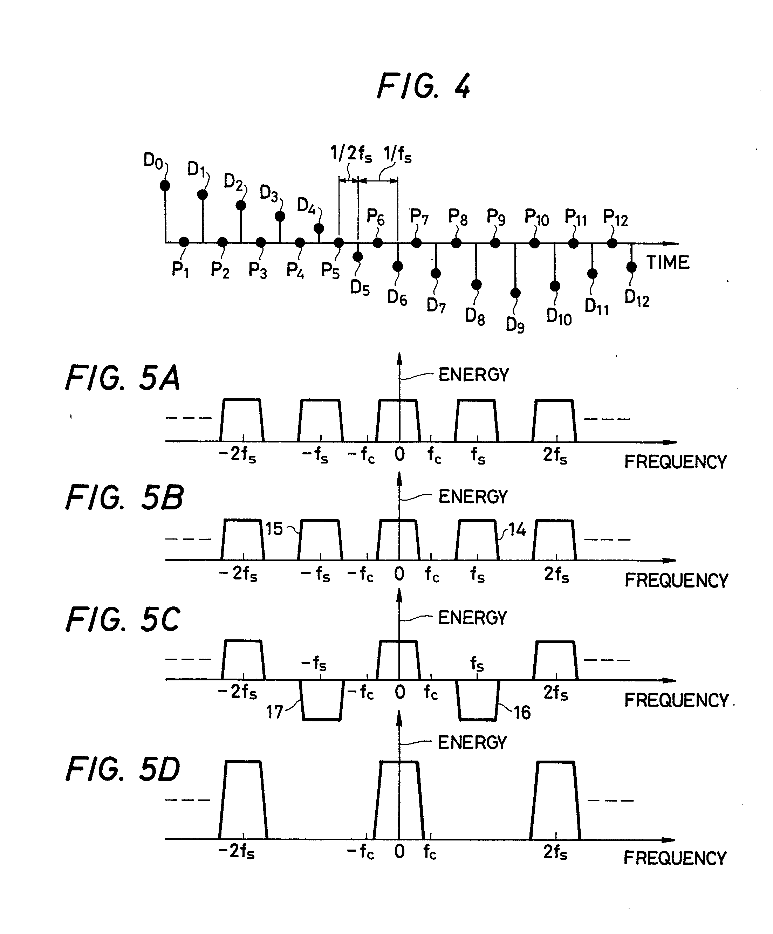

Reference numeral 12 in Fig. 2 designates the transfer characteristics of the low pass filter. Reference numeral 13 in Fig. 3 denotes the impulse response of the filter having the characteristics shown in Fig. 2 and marks "o" and marks "x" designate the sampled points sampled by 1/2fs sampling period. Fig. 4 shows the time series signals interpolated 0 (zero) to the input signals. Symbols $D_0$ to $D_{12}$ designate the input signals sampled by the sampling frequency fs and $P_1$ to $P_{12}$ denote interpolated 0s. The sampling period of the input signals sampled by fs can be converted to 2 times by taking the outputs of the convolution every 1/2fs time interval using the time series signals interpolated 0 shown in Fig. 4 and the impulse response sampled by the sampling frequency 2fs shown in Fig. 3. Figs. 5A to 5D are the illustration of this reason with respect to the spectrum of the signal. Fig. 5A shows the spectrum of the input signal sampled by the frequency fs. Fig. 5B shows the spectrum of the time series signals picked up only to show the results of the operation. in the case that the coefficients multipled by $D_0$ to $D_{12}$ in the time series signal shown in Fig. 4 are the o marked $C_0$, $C_2$,...$C_{24}$ shown in Fig. 3 when the convolution is carried out. Fig. 5C shows the time series signals picked up only to show the results of the operation in the case that the coefficients multiplied by $D_0$ to $D_{11}$ in the time series signal shown in Fig. 4 are the x marked $C_1$, $C_3$, $C_5$, ...., $C_{23}$ in Fig. 3 when the convolution is carried out. In the above mentioned operations, since the operation resulting in the output time series being the spectrum of Fig. 5B and the operation resulting in the output time series being the spectrum of Fig. 5C, are carried out at every time interval of 1/2fs and the results are taken out alternately, the output spectrum of the digital filter becomes the sum of the spectrum shown in Fig. 5B and the spectrum shown in Fig. 5C. The components 14 and 15 which are the components folded at $\pm$ (2n-1) x fs (n=1,2,3,...) as the center of the spectrum shown in Fig. 5B cancel the components 16 and 17 which are the components folded at $\pm$ (2n-1) x fs (n=1,2,3, ...) as the center of the spectrum shown in Fig. 5C. As a result, the output spectrum becomes the spectrum shown in Fig. 5D. By comparing the spectrum of Fig. 5D to the spectrum of Fig. 5A it can be understood from the sampling theory that the sampling frequency is converted to 2 times frequency.

In the above mentioned operations, in the case that the coefficients multiplied by $D_0$ to $D_{12}$ in Fig. 4 are the o marked $C_0$, $C_2$, $C_4$, ..., $C_{24}$ in Fig. 3, the coefficients multiplied by the $P_1$ to $P_{12}$ in Fig. 4 are the x marked $C_1$, $C_3$, $C_5$, ..., $C_{23}$ in Fig. 3. In the case that the coefficients multiplied by the $D_0$ to $D_{11}$ in Fig. 4 are the x marked $C_1$, $C_3$, $C_5$, ..., $C_{23}$ in Fig. 4, the coefficients multiplied by the $P_1$ to $P_{12}$ in Fig. 4 are the o marked $C_0$, $C_2$, $C_4$, ..., $C_{24}$ in Fig. 3. As $P_1$ to $P_{12}$ equal to zero, carrying out the convolution between the time series signal in Fig. 4 and the coefficients in Fig. 3 in $1/2fs$ interval, is the same that the convolution between $D_0$ to $D_{12}$ in Fig. 4 and the o marked coefficients in Fig. 3 and the convolution between $D_0$ to $D_{12}$ and the x marked coefficients in Fig. 3 are carried out alternately.

In the next, the conversion of the sampling frequency $2fs$ of the input signals to $1/2$, that is $fs$, is explained. In the case of converting the sampling frequency to $1/2$, it is only necessary to carry out the convolution using the input signals taken in the time interval $1/2fs$ and the coefficients of both o and x marked $C_0$ to $C_{24}$ in Fig. 3 and to take out the results in the time interval $1/fs$. Namely, it is only necessary to take the input signals, which are inputted in every 1/2fs time interval, two at a time in every 1/fs time interval and to carry out the convolution between these signals and the coefficients shown in Fig. 3.

It is an embodiment shown in Fig. 1 that it is devised to be able to convert the sampling frequency of the input signals to both 2 times and 1/2 by the above depicted method. In the embodiment when the mode is in converting the sampling frequency to 2 times, the processing is carried out for the two kinds of signals taken in time division. The two kinds of signals are, for example, the left channel signal and the right channel signal in an audio system. When the mode is in converting the sampling frequency to 1/2, the processing is carried out for one kind of the input signal.

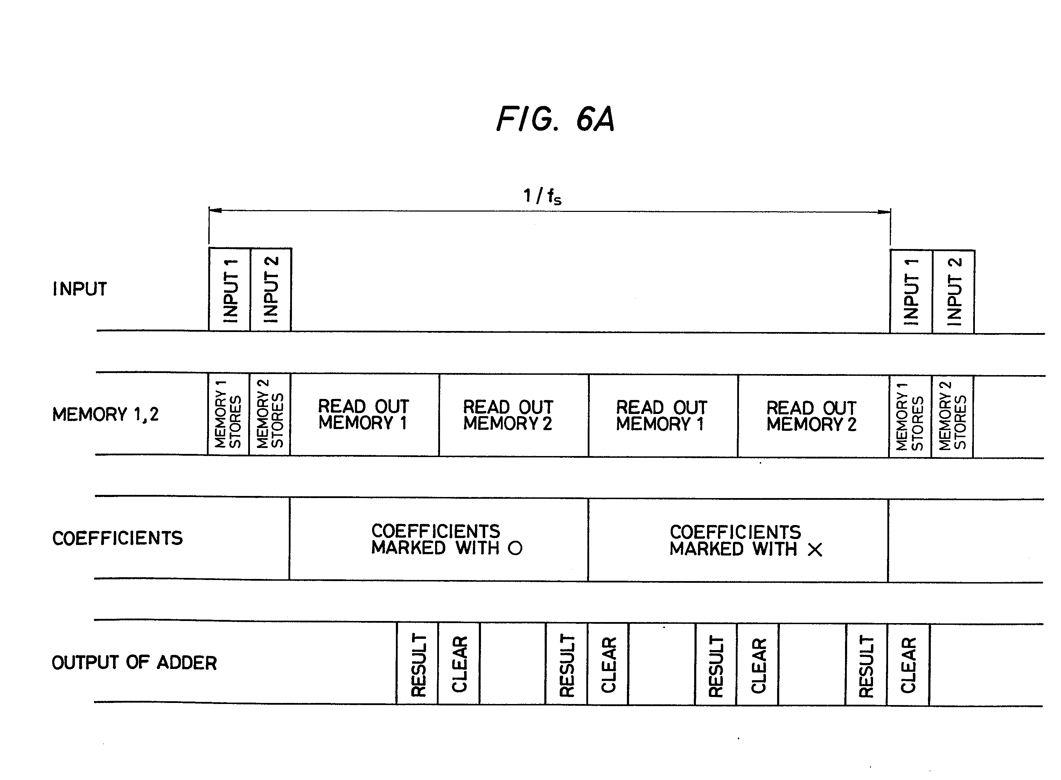

The mode of converting the sampling frequency to 2 times is explained referring to Fig. 6A. Two kinds of the input signals taken by the time division are stored in the memory 1 and in the memory 2 separately through the switch 7 whose switching action is controlled by the control circuit 3. Next, the input signal stored in the memory 1 and the o marked coefficients in Fig. 3 from among the coefficients stored in the coefficient memory 4 are read out sequentially and multiplied by the multiplier 5 and the results are accumulated by the adder 6 and the output 9 of the convolution are taken out as outputs. After that, the adder 6 is cleared and the same processing above mentioned is carried out by using the signals stored in the memory 2 and the o marked coefficients stored in the coefficient memory 4. Furthermore the same processing is repeated using the signals stored in the memory 1 and the x marked coefficients stored in the coefficient memory 4 and finally the processing is carried out using the memory 2 and the x marked coefficients stored in the coefficient memory 4.

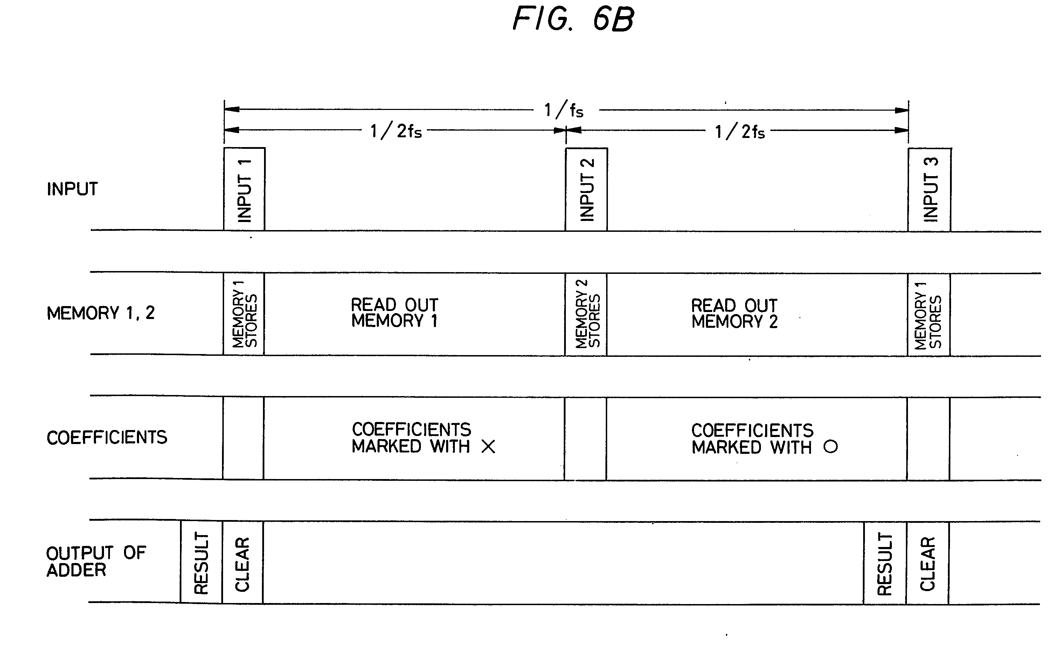

In the next, the conversion of the sampling frequency to 1/2 is explained referring to Fig. 6B. In the case of converting the sampling frequency to 1/2, in order to carry out the aforementioned operations by the low pass filter which has the same characteristics as shown in Fig. 2, the number of data necessary for one channel is twice more than the case of converting the sampling frequency to 2 times. Because of this in the case of converting the sampling frequency to 1/2, the memories 1 and 2 are used as one memory channel for storing only one channel data number of which is twice more than that of the data for one channel in the case of converting the sampling frequency to 2 times, although the memories 1 and 2 are used as two independent memory channels for storing two channel data respectively in the case of converting the sampling frequency to 2 times.

The switch 7 and the memories 1 and 2 are controlled by the control circuit 3 and the input signals 8 which are inputted in every $1/2fs$ time interval are stored in the memories 1 and 2. When the symbol $xi$ represents the input signal and the signals $X_1$, $X_2$, $X_3$, $X_4$,... are serially in-

putted, $X_1$ is stored in the memory 1, $X_2$ is stored in the memory 2, $X_3$ in the memory 1, $X_4$ in the memory 2 and so on, so that the serial data for one channel are stored in both memory 1 and memory 2. The memories 1 and 2 store every other datum inputted in every 1/2fs time interval.

A first input signal stored in the memory 1 is·read out and multiplied by the x marked coefficients (shown in Fig. 3) read out from the coefficient memory 4, and the results are accumulated by the adder 6. In the next, a second signal stored in the memory 2 is read out and multiplied by the o marked coefficients (shown in Fig. 3) read out from the memory 4, and the results are accumulated by the adder 6. Both results of these operations are added together. The adding is done by carring out the operation using the o marked coefficients without clearing the results of the operation using the x marked coefficients. The results of convolution are delivered out in every 1/fs time interval in contrast to that the input signals are applied in every 1/2fs time interval. Carring out the above operations in response to the input signals which is inputted in every 1/2fs time interval and whose sampling frequency is 2fs, the output signals which pass through the low pass filter having the characteristics shown in Fig. 2 and whose sampling frequency is converted to fs are obtained.

In the above embodiment, the odd numberth input signals are stored in the memory 1 and the even numberth input signals are stored in the memory 2. However, the input signals from the first to the n th ($X_1$, $X_2$, $X_3$, .... Xn) can be serially stored in the memory 1 and the input signals from the n+1 th to the 2n th ($X_{n+1}$, $X_{n+2}$, $X_{n+3}$... $X_{2n}$) can be serially stored in the memory 2. In this case, when the x marked coefficients are to be used to the operation, the odd numberth input signals are read out from the memories 1 and 2, and when the o marked coefficients are to be used, the even numberth input signals are read out from these memories.

In such a way, by storing the input signal taken in every 1/2fs time interval two at a time, and carrying out the convolution between the input signals and the filter coefficients every 1/fs time interval, the conversion of the sampling frequency to 1/2 can be attained.

As is understood from the above explanation, this embodiment has the effect that the conversion of the sampling frequency to both 2 times and to 1/2 can be attained.

In the embodiment, although only the case of converting the sampling frequency to 2 times and 1/2 are considered for simplicity, the conversion of the sampling frequency to m times can be attained by storing the coefficients sampled in the frequency m x fs in the coefficient memory 4 and carrying out periodically with the 1/(m x fs) period the convolution between the input signals and each coefficient of the (m-1) interval, and also the conversion of the sampling frequency to 1/n can be attained by carrying out one convolution for every n input signals and taking out the results.

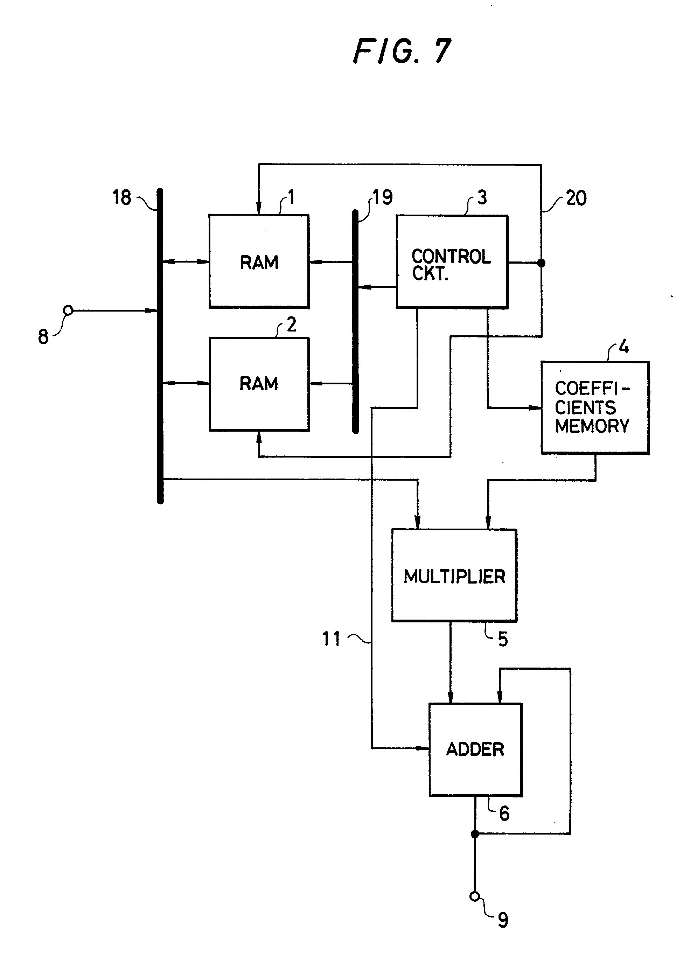

In the following, another embodiment of the present invention is explained referring to Fig. 7. Fig. 7 is the example of constructing the memories of this invention using RAM (randum access memory), and the components denoted by the same reference numerals as Fig. 1 are the same components as Fig. 1. Reference numeral 18 denotes the data bus for RAM 1 and RAM 2, 19 the address bus for the RAM 1 and RAM 2, and 20 the input/output control signal for the RAM 1 and RAM 2. The address space is constructed so as the determine one position in the memory through RAM 1 and RAM 2 when the address is taken out to the address bus 19 by the control circuit 3. In the case of storing the input signals to the RAM 1 and RAM 2, the address is taken out to the address bus 19 by the control circuit 3 and at the same time the input/output control signal 20 is turned to the input mode and then the input signal 8 that appeared on the data bus 18 is stored. In the case of taking out the signals stored in the RAM 1 and RAM 2, the address is taken out to the address bus 19 by the control circuit 3 and at the same time the input/output control signal 20 is turned to the output mode and the stored signal is taken out to the data bus 18 and is given to the multiplier 5. In this way, the signals are stored in the RAM 1 and RAM 2 and by the same way as the first embodiment, the digital filter being able to convert the

**0 173 307**

sampling frequency of the input signals can be constructed.

In the next, the embodiment wherein the present invention is applied to an audio system is described.

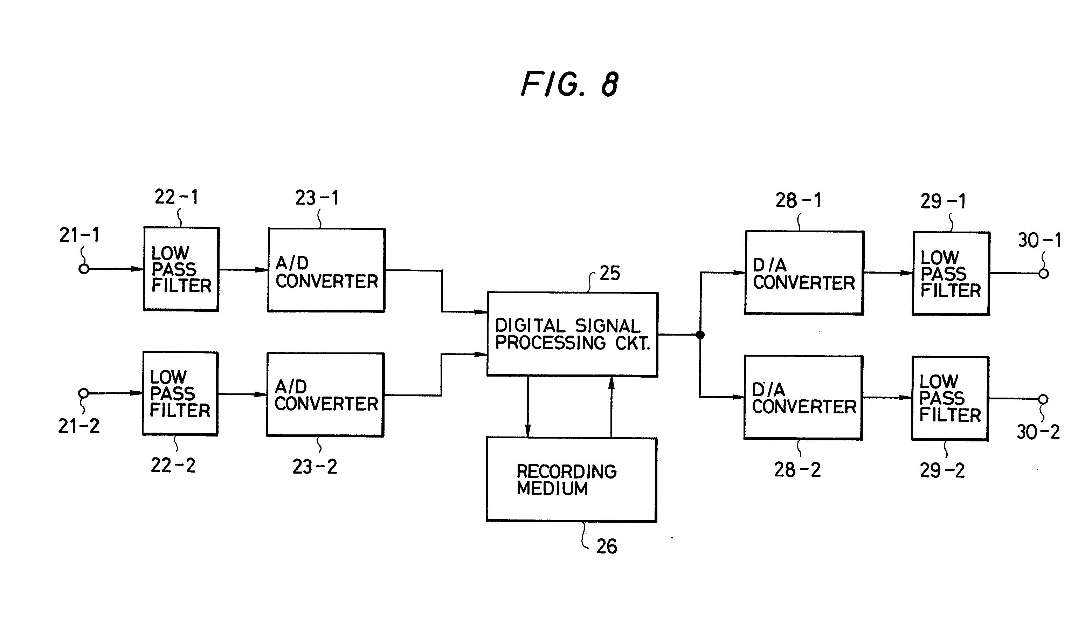

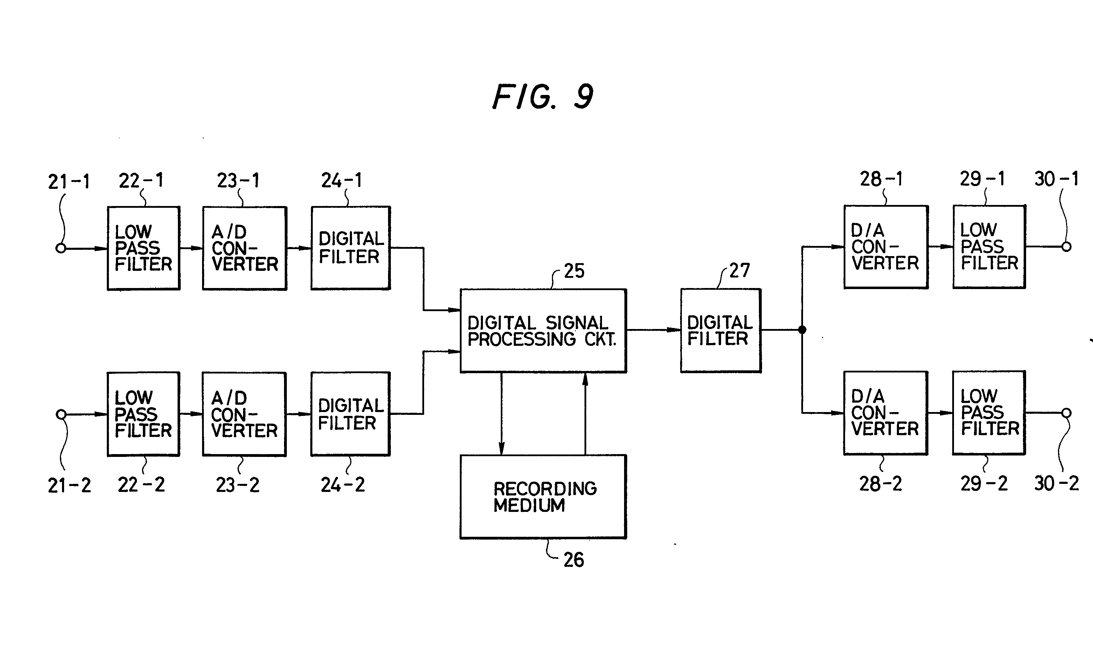

Fig. 8 shows the recording and reproducing system of the digital audio system. Reference numeral 21-1 designates audio input signals for the left channel (in the following, this is abbreviated to L-ch input), 21-2 input signals for the right channel (in the following, this is abbreviated to R-ch input), 22-1 and 22-2 the low pass filters (in the following, these are abbreviated to LPFs) respectively, and 23-1 and 23-2 analog to digital converters (in the following, these are abbreviated to A/D converters) respectively. Reference numeral 25 denotes a digital signal processing circuit for digital recording and reproducing, and 26 a medium for signal recording. Reference numerals 28-1 and 28-2 designate digital to analog converters (in the following, there are abbreviated to D/A coverters), 29-1 and 29-2 LPFs, respectively, 30-1 audio output signals for the left channel (in the following, this is abbreviated to L-ch channel output), and 30-2 audio output signal for the right channel (in the following, this is abbreviated to R-ch output). In the first, when the input signals are recorded to the recording medium 26, the bandwidth of the L-ch input and R-ch input are restricted to narrower than one half of the sampling frequency of the A/D converters 23-1 and 23-2 and are converted to digital signals by the A/D converters 23-1 and 23-2. These digital signals are recorded on the recording medium 26 after processed by the processing circuit 25. In the next, when the signals recorded in the recording medium 26 are reproduced, the recorded signals are read out from the recording medium 26 and processed by the digital signal processing circuit 26 and converted to analog signals by the D/A converters 28-1 and 28-2. Furthermore the high frequency components are eliminated by the LPFs 29-1 and 29-2, and thus the L-ch output 30-1 and R-ch output are reproduced. In such systems, the characteristics of the LPFs 22-1 and 22-2 may be loose as higher the sampling frequency of the output signals of the A/D coverters 23-1 and 23-2 are, and those of the LPFs 29-1 and 29-2 may be loose as higher the sampling frequency of the input signals to the D/A converters 28-1 and 29-1 are. It is in Fig. 9 that the solution is shown and reference numerals 24-1, 24-2 and 27 denote the digital filters according to the present invention. When the signals are recorded, the signals are sampled by the A/D converters 23-1 and 23-2 whose sampling frequency are set to higher than the sampling frequency in the case of recording on the recording medium 26, and then the high frequency components are eliminated by the digital filters 24-1 and 24-2 and at the same time the sampling frequency are lowered down, and signals are processed by the digital processing circuit 25, and recorded to the recording medium 26. In the case of reproducing signals, after the signals which are read out from the recording medium 26 are processed by the digital signal processing circuit 25, the high frequency components are eliminated by the digital filter 27 and at the same time the sampling frequency are set to higher, and furthermore the signals are coverted to analog signals by the D/A coverters 28-1 and 28-2, and finally the L-ch output and R-ch output are reproduced by passing the base band components through LPFs 29-1 and 29-2. As above mentioned, higher performance of a digital audio system can be attained by applying the nonrecursive digital filter of the present invention to a digital audio system due to the fact that in the case of constructing the digital audio system by LSI for the digital filter according to the present invention, the characteristics of the LPF used prior to the A/D converter at the time of recording and of the LPF used post the D/A converter at the time of reproducing are made to be not severe by using one LSI with time division use or by using plural LSIs of one type. Also, the sharp cut off and linear phase characteristics, which can be attained by the nonrecursive digital filter of the present invention, make a digital audio system higher performance.

According to the present invention, the sampling frequency of the input signals can be converted to either m times of $1/n$ (m=2,3,4,..., n=2,3,4,...) in the nonrecursive digital filter. There is the effect that the sampling frequency of the input signals can be converted to both m times and 1/n by using one nonrecursive digital filter.

Claims

1. A nonrecursive type digital filter comprising;

a first memory for storing input signals;

a second memory for storing input signals;

a coefficient memory for storing constant coefficient;

a multiplier for multiplying the signal stored in the first and second memories by coefficients stored in the coefficient memory;

an adder for adding the output of the multiplier to the output thereof; and

a control circuit for controlling the first and second memories whether to be used as two independent memory channels or as one memory channel.

2. A nonrecursive type digital filter according to claim 1, wherein said first and second memories are respectively composed of read and write memory devices, and said control circuit is composed of a address control circuit for the read and write memory devices.

3. A nonrecursive digital filter according to claim 1, wherein said input signals are signals to be recorded on a recording medium or signals reproduced from a recording medium; in the case that the input signals are the signals to be recorded, said control circuit controls said first and second memories so as to store the input signals as one memory channel; and in the case that the input signals are the signals reproduced, said control circuit controls said first and second memories so as to store the input signals as two independent memory channels.

4.     A nonrecursive digital filter according to claim 3, wherein said signals to be recorded are digitized audio signals, and said signals reproduced are signals reproduced from a recording medium on which digitized audio siginals have been recorded.

# FIG. 1

2/8

## FIG. 2

AMPLITUDE

12

0  $f_c$  $f_s/2$  $f_s$  $2f_s$

FREQUENCY

## FIG. 3

AMPLITUDE

$1/f_s$

$C_{10}$  $C_{11}$  $C_{12}$  $C_{13}$

13  $C_{14}$

$C_9$  $C_{15}$

$1/2f_s$

$C_1$  $C_2$  $C_3$  $C_4$  $C_{16}$  $C_{21}$  $C_{22}$  $C_{23}$  $C_{24}$

$C_0$  $C_8$  $C_{20}$  TIME

$C_5$  $C_6$  $C_7$  $C_{17}$  $C_{18}$  $C_{19}$

0 173 307

21/8

FIG. 4

FIG. 5A

FIG. 5B

FIG. 5C

FIG. 5D

FIG. 6A

0173307

## FIG. 6B

| INPUT | INPUT 1 | | INPUT 2 | | INPUT 3 |
| MEMORY 1, 2 | MEMORY 1 STORES | READ OUT MEMORY 1 | MEMORY 2 STORES | READ OUT MEMORY 2 | MEMORY 1 STORES |
| COEFFICIENTS | | COEFFICIENTS MARKED WITH × | | COEFFICIENTS MARKED WITH ○ | |
| OUTPUT OF ADDER | RESULT / CLEAR | | | RESULT | CLEAR |

1/fs

1/2fs          1/2fs

## FIG. 7

FIG. 8

## FIG. 9